# EUROPEAN PATENT SPECIFICATION

(11) **EP 4 439 671 B1**
(45) Date of publication and mention of the grant of the patent: **26.08.2026**
(21) Application number: 24161903.0
(22) Date of filing: 07.03.2024
(51) Int. Cl.: H10F 39/18, H10F 39/00

(54) **RADIATION DETECTOR AND RADIATION IMAGING SYSTEM**
STRAHLUNGSDETEKTOR UND STRAHLUNGSBILDGEBUNGSSYSTEM
DÉTECTEUR DE RAYONNEMENT ET SYSTÈME D'IMAGERIE PAR RAYONNEMENT

(30) Priority: 16.03.2023 JP 2023042104; 12.12.2023 JP 2023209515
(43) Date of publication of application: 02.10.2024
(73) Proprietor: CANON KABUSHIKI KAISHA, Tokyo 146-8501 (JP)
(72) Inventor: IDE, Kunihito, Tokyo (JP)
(74) Representative: WESER & Kollegen Patentanwälte PartmbB

(56) References cited:
- EP-A1- 1 672 694
- JP-A- H0 629 506
- US-A1- 2007 272 997
- US-A1- 2022 085 094

## Description

### BACKGROUND OF THE INVENTION

### Field of the Invention

The present technology relates to a radiation detector and the like.

### Description of the Related Art

There is known a radiation detector that obtains a radiation image by receiving radiation with a semiconductor element such as a CMOS imaging sensor without through a scintillator (wavelength converter). In such a radiation detector, when radiation intrudes into a deep portion of a semiconductor element, since crosstalk or secondary electrons are generated, and detection accuracy is reduced, thinning of a semiconductor layer is performed.

JP 2019-87640 A discloses a detector in which the thickness of a semiconductor layer in at least a part of a detection region is smaller than the thickness of a peripheral region. It is described that in the detection region of the semiconductor layer, a plurality of grooves is provided on a rear surface opposite to a surface on which an energy ray is incident to reduce crosstalk between pixels.

JP 2021-18988 A discloses that when manufacturing a charged particle detector including a sensitive layer, a mechanical support layer, and a substrate layer, a step of thinning the substrate layer is performed after the mechanical support layer is connected to an opposite side of the substrate layer with the sensitive layer interposed therebetween.

JP 2012-38726 A discloses that in a direct type electronic detector, a part or all of a material disposed immediately below a detection unit of a sensor is removed to prevent electrons scattered by the material from returning to the detector.

When a semiconductor element (semiconductor layer) is thinned, generation of crosstalk and secondary electrons can be reduced, but the mechanical strength of the semiconductor element may be reduced, and there is a limit to thinning. On the other hand, in general, other members are disposed around the semiconductor element so as to be in contact with the semiconductor element, but if radiation is scattered inside the semiconductor layer when passing through the semiconductor layer, the members may be irradiated with the scattered radiation. When the scattered radiation is further scattered or reflected by a surrounding member, a part of the scattered radiation may return to the semiconductor layer again and generate noise.

JP 2012-38726 A discloses a technology of preventing electrons scattered by the member disposed immediately below the detection unit of the sensor from returning to the detector, but sufficient consideration is not made on members disposed at positions other than immediately below the detection unit.

Therefore, there has been a demand for a radiation detector capable of solving the problem that the radiation scattered inside the semiconductor layer is emitted to a surrounding member disposed at positions other than immediately below the detection unit, is further scattered or reflected by the surrounding member, returns to the semiconductor layer again, and generates noise. EP 1 672 694 A1 discloses a semiconductor device with a semiconductor substrate, a wiring substrate, conductive bumps, and a resin, wherein a CCD and a thinned portion are formed on the semiconductor substrate.

### SUMMARY OF THE INVENTION

The present invention in its first aspect provides a radiation detector as specified in claims 1 to 13.

The present invention in its second aspect provides a radiation imaging system as specified in claims 14 and 15, which are dependent on any of claims 1 to 13.

Further features of the present invention will become apparent from the following description of exemplary embodiments with reference to the attached drawings.

### BRIEF DESCRIPTION OF THE DRAWINGS

FIG. 1A is a schematic cross-sectional view of a radiation detector 1 according to an embodiment.
FIG. 1B is a plan view of the radiation detector 1 when viewed from a direction in which radiation is incident.
FIG. 2 is a partially enlarged cross-sectional view in which a right side portion of FIG. 1A is enlarged.
FIG. 3 is a view schematically illustrating a state in which radiation R emitted to the vicinity of an outer edge of a detection region PA is scattered.
FIG. 4 is a partially enlarged cross-sectional view of a right side portion of a radiation detector 1 according to Embodiment 2.
FIG. 5 is a partially enlarged cross-sectional view of a right side portion of a radiation detector 1 according to Embodiment 3.
FIG. 6 is a schematic view illustrating a radiation detection apparatus APR according to Embodiment 4.
FIG. 7A is a partially enlarged cross-sectional view of a right side portion of a radiation detector according to Embodiment 5.
FIG. 7B is a partially enlarged cross-sectional view of a right side portion of an appropriate radiation detector according to Embodiment 5.
FIG. 8A is a schematic view illustrating adhesion of foreign substances on an adhesive surface.
FIG. 8B is a partially enlarged cross-sectional view of a right side portion of a radiation detector according to Embodiment 6.
FIG. 9 is a partially enlarged cross-sectional view of a right side portion of a radiation detector according to Embodiment 7.
FIG. 10A is a partially enlarged cross-sectional view of a right side portion of a radiation detector according to Embodiment 8.
FIG. 10B is a schematic diagram illustrating a difference in linear expansion coefficient.
FIG. 11 is a schematic view illustrating a modification example according to Embodiment 4.
FIG. 12 is a schematic view illustrating a radiation imaging system according to Embodiment 9.
FIG. 13 is a schematic view illustrating a radiation imaging system according to Embodiment 10.

### DESCRIPTION OF THE EMBODIMENTS

A radiation detector according to an embodiment of the technology will be described with reference to the accompanying drawings.

Note that, in the drawings referred to in the following description of the embodiments, it is assumed that elements denoted by the same reference numerals have the same functions unless otherwise stated. In the drawings, in a case where a plurality of the same elements is disposed, reference numerals and description thereof may be omitted. In addition, since the drawings may be expressed schematically for convenience of illustration and explanation, it is assumed that there may be a case where shapes, sizes, arrangements, and the like of elements described in the drawings may not strictly match those of actual objects.

In addition, in the following description, for example, in a case of description as a positive X-direction, it is assumed that the direction represents the same direction as indicated by an X-axis arrow in an illustrated coordinate system, and in a case of a negative X-direction, it is assumed that the direction represents a direction opposite to the direction indicated by the X-axis arrow by 180 degrees in the illustrated coordinate system. In addition, in a case of simple description as an X-direction, it is assumed that the direction is parallel to the X-axis regardless of a difference from the direction indicated by the illustrated X-axis arrow. The same shall apply to directions other than X.

Radiation detected by the radiation detector according to the embodiments may be an electromagnetic wave or a corpuscular ray. The electromagnetic wave may be a light ray such as an infrared radiation, a visible light, and an ultraviolet radiation, a radio wave such as a microwave, or an ionizing radiation such as an X-ray or a gamma ray. Examples of the corpuscular ray include an alpha beam, a beta beam, an electron beam, a neutron beam, a proton beam, a heavy ion beam, and an intermediate beam. A structure of the radiation detector, for example, the thickness of a semiconductor layer that converts the radiation into an electrical signal may be appropriately set in correspondence with transmission characteristics and absorption characteristics of the radiation to be detected.

### Embodiment 1

### Configuration of Radiation Detector

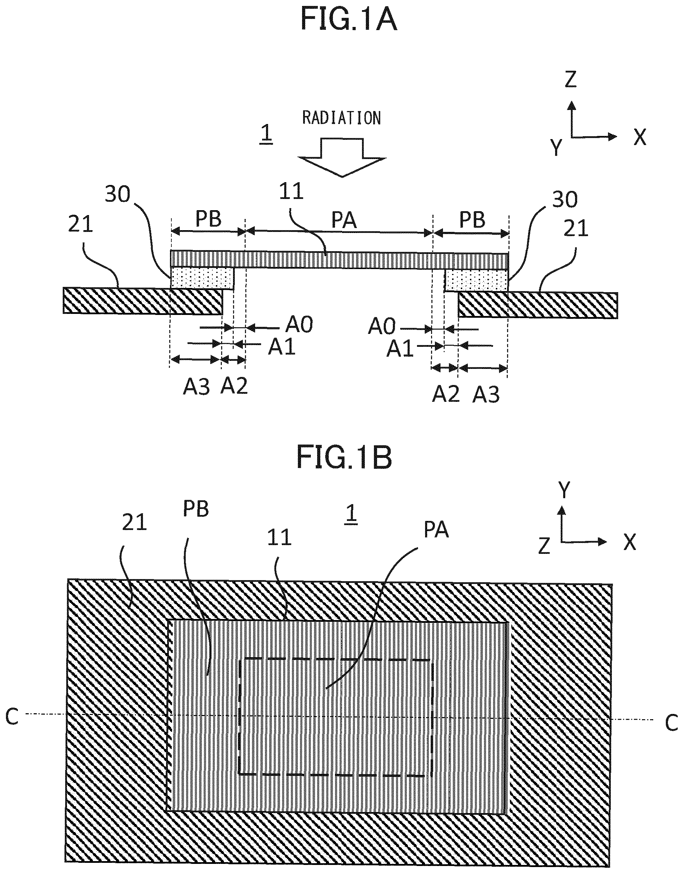

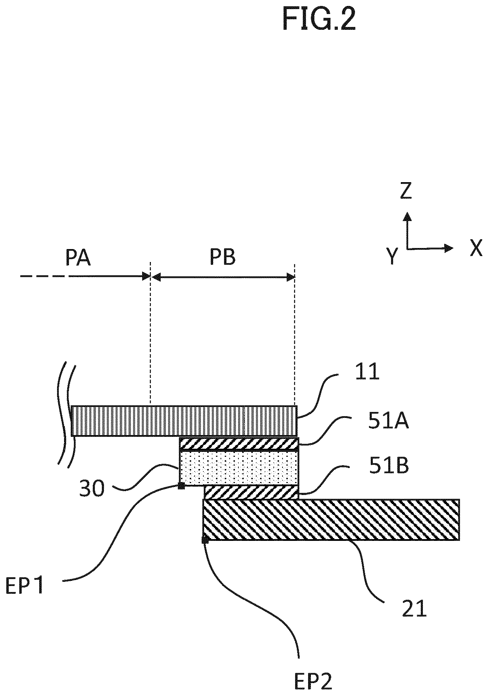

With regard to a radiation detector 1 according to this embodiment, FIG. 1A is a cross-sectional view thereof, and FIG. 1B is a plan view when viewed from a direction in which radiation is incident. Note that, FIG. 1A shows a cross-section taken along line C-C in FIG. 1B. In addition, FIG. 2 is a partially enlarged cross-sectional view in which a right side portion of FIG. 1A is enlarged.

The radiation detector 1 includes a semiconductor layer 11, a first support member 30, and a second support member 21. The semiconductor layer 11 consists of a single crystal layer of silicon, germanium, or the like, or a polycrystalline layer, and includes a detection region PA as a light-receiving portion and a peripheral region PB provided outside the detection region PA. Although shown as a frame shape surrounding the detection region PA in FIG. 1B, the peripheral region PB is a region other than the detection region PA.

The detection region PA as a light-receiving portion is a region provided with a detection element that converts electrons generated by incidence of radiation into an output signal, and has a structure in which a plurality of pixels and read circuits for forming an image based on radiation are arranged in a matrix. The light-receiving portion can be said to be a region into which radiation is incident or a detection unit. Each of the plurality of pixels can include a photodiode in a similar manner as in a CMOS image sensor or a CCD. As the photodiode, a compound semiconductor such as CdTe (cadmium telluride) or CdZnTe (cadmium-zinc telluride) may be used. In addition, a photon counting principle may be used, and a device such as a single photon avalanche diode (SPAD) may be used.

The detection region PA can be provided with a circuit that transfers electrons accumulated in the photodiode to a floating diffusion region via a transfer transistor and reads out a potential via a source follower in a similar manner as in the CMOS image sensor and the CCD. A circuit in which the potential of the accumulation portion is directly set as a gate potential of the source follower without using a transfer transistor may be provided.

The thickness of the detection region PA (the thickness in a direction orthogonal to a main surface of the semiconductor layer 11) may be 10 µm to 100 µm in consideration of the balance between prevention of crosstalk and securing of mechanical strength, and preferably 25 µm to 75 µm. Typically, the thickness is set to 50 µm.

Peripheral circuits such as a drive circuit, a control circuit, a signal processing circuit, and an output circuit, an input terminal, and an output terminal are provided in the peripheral region PB. The drive circuit is a circuit that scans and drives the read circuit of each pixel in the detection region PA. The control circuit is a circuit that controls drive timing of the drive circuit, the signal processing circuit, and the like, and includes a timing generator and the like. The signal processing circuit processes a signal read from the read circuit of the detection region PA, and includes an amplification circuit and an AD conversion circuit. The output circuit converts a signal obtained by the signal processing circuit into a predetermined format and outputs the converted signal, and includes a differential transmission circuit. The input terminal is a terminal to which power or a control signal is input from the outside, and the output terminal is a terminal that outputs a signal to the outside.

In the semiconductor layer 11, when a main surface on a radiation incident side is referred to as a front surface, and a main surface on the opposite side is referred to as a rear surface, a part of the peripheral region PB of the rear surface faces the first support member 30.

A part of the peripheral region PB faces the second support member 21 with the first support member 30 interposed therebetween. In other words, when the radiation detector 1 is seen through from the front surface side along a direction (Z-direction) orthogonal to the main surface of the semiconductor layer 11, a part of the peripheral region PB overlaps the first support member 30.

Further, a part thereof also overlaps the second support member 21. That is, as illustrated in FIG. 1A, a region A0, a region A1, and a region A3 exist in the peripheral region PB. The region A0 is adjacent to a boundary between the detection region PA and the peripheral region PB, and is a portion where the semiconductor layer 11 does not overlap any of the first support member 30 and the second support member 21. The region A1 is a portion where the semiconductor layer 11 overlaps the first support member 30 but does not overlap the second support member 21, and the region A3 is a portion where the semiconductor layer 11 overlaps both the first support member 30 and the second support member 21. Note that, time when the radiation detector 1 is seen through from the direction (Z-direction) orthogonal to the main surface of the semiconductor layer 11 is also referred to as time when the radiation detector 1 is viewed in plan view.

Although not illustrated in FIG. 1A for convenience of illustration, as can be seen with reference to FIG. 2, in a region where the rear surface of the semiconductor layer 11 and the first support member 30 face each other, these members are bonded by an adhesive layer 51A. In a region where the first support member 30 and the second support member 21 face each other, the first support member 30 and the second support member 21 are bonded to each other by an adhesive layer 51B. For the adhesive layer 51A and the adhesive layer 51B, adhesive is used, but a die attach film (DAF), a double-sided tape, or the like may be used in some cases. Note that, in each region, the entire surfaces facing each other may not be bonded by the adhesive layer 51A and the adhesive layer 51B, and at least a part thereof may be bonded.

The second support member 21 is a substrate on which an electric circuit for achieving various functions is mounted. Specific functions include supplying of a control signal and power to a radiation detection sensor provided in the semiconductor layer 11, processing of a signal output from the semiconductor layer 11, storing of a signal, transmitting of a signal to an external computer or network, and the like. An input terminal and an output terminal of the second support member 21 and the semiconductor layer 11 are electrically connected via wire bonding (not illustrated). However, a method of electrically connecting the second support member 21 and the semiconductor layer 11 may be a method other than wire bonding.

The first support member 30 and the second support member 21 may be members for effectively transmitting heat of the semiconductor layer 11 and the second support member 21 to a cooling device (not illustrated). For example, a material having high thermal conductivity such as Mo, CuW, CuMo, Si, SiC, SiN, AlN, Al₂O₃, and synthetic diamond is suitably used.

In a case where an end face of the first support member 30 is located at the boundary between the detection region PA and the peripheral region PB, radiation scattered in the semiconductor layer 11 is scattered or reflected by the first support member 30, and a part of the radiation returns to the semiconductor layer 11 again. As a result, noise may be generated. In a similar manner, in a case where an end face of the second support member 21 is located immediately below the boundary between the detection region PA and the peripheral region PB, radiation scattered inside the semiconductor layer 11 is scattered or reflected by the second support member 21, and a part of the radiation returns to the semiconductor layer 11 again. As a result, noise may be generated.

In contrast, in this embodiment, as shown in FIG. 1A, the end face of the first support member 30 on the detection region PA side is offset toward a side of the peripheral region (PB side) from the boundary between the detection region PA and the peripheral region PB. That is, when the semiconductor layer 11 is seen through from the front surface side along a direction (Z-direction) orthogonal to the main surface, the end face of the first support member 30 is located on the peripheral region PB side by the region A0 of the peripheral region PB from the boundary between the detection region PA and the peripheral region PB. The width of the region A0 (the width in a direction parallel to the main surface of the semiconductor layer 11) is, for example, 200 µm.

An end face of the second support member 21 on the detection region PA side is located further away from the boundary between the detection region PA and the peripheral region PB as compared with the end face of the first support member 30. That is, when the semiconductor layer 11 is seen through from the front surface side along a direction (Z-direction) orthogonal to the main surface, the end face of the second support member 21 is located on the peripheral region PB side by the region A2 (region A0 + region A1) on the side of the peripheral region (PB side) as compared with the boundary between the detection region PA and the peripheral region PB. The width of the region A2 (the width in a direction parallel to the main surface of the semiconductor layer 11) is, for example, 700 µm.

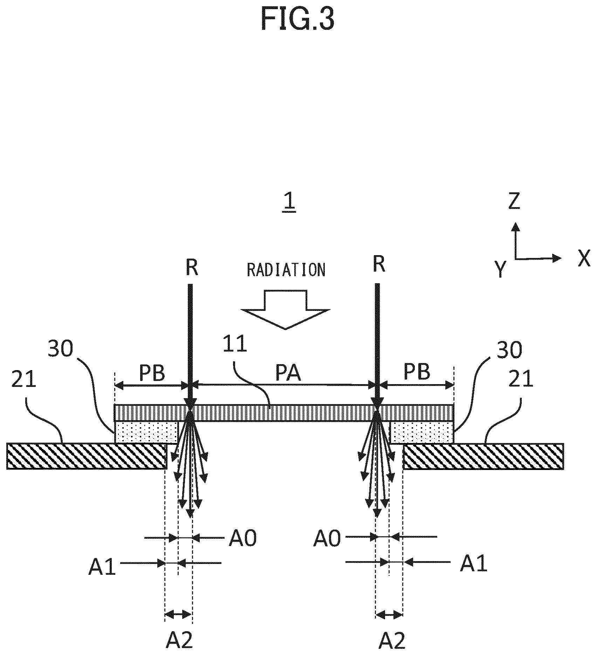

As illustrated in FIG. 2, in the first support member 30, a point at which a side surface on a side of the detection region (PA side) and a lower surface intersect each other is referred to as EP1, and in the second support member 21, a point at which a side surface on the side of the detection region (PA side) and a lower surface intersect each other is referred to as EP2. When the radiation detector 1 is seen through from a direction orthogonal to an incident surface of the semiconductor layer 11, EP1 is spaced apart from the boundary between the detection region PA and the peripheral region PB by a first distance (a width of the region A0 in FIG. 1A). Further, EP2 is spaced apart from the boundary between the detection region PA and the peripheral region PB by a second distance (a width of the region A2 in FIG. 1A) larger than the first distance. The effect will be described with reference to FIG. 3.

FIG. 3 schematically illustrates an aspect in which the radiation R emitted to the vicinity of the outer edge of the detection region PA (the vicinity of the boundary with the peripheral region PB) is scattered. This is because the peripheral members may be most likely to be irradiated with radiation scattered in the vicinity of the outer edge of the detection region PA among rays of radiation scattered in the detection region PA of the semiconductor layer 11.

According to this embodiment, a space (region A0) is provided between the semiconductor layer 11 and the first support member 30. Therefore, among rays of radiation scattered inside the semiconductor layer 11, only a small amount of radiation is incident on the side surface (end portion) of the first support member 30, and the other radiation passes in a downward direction (a negative Z-direction) without being incident on the side surface. Since the amount of radiation scattered or reflected on the side surface of the first support member 30 is very small, the radiation that is incident again to the semiconductor layer 11 is reduced, and generation of noise is suppressed.

According to this embodiment, a space (region A2) is provided between the semiconductor layer 11 and the second support member 21. Therefore, among rays of radiation scattered inside the semiconductor layer 11, only a small amount of the radiation is incident on the side surface of the second support member 21, and the other radiation passes in a downward direction (a negative Z-direction) without being incident on the side surface. Since the amount of radiation scattered or reflected on the side surface of the second support member 21 is very small, the radiation that is incident again to the semiconductor layer 11 is reduced, and the generation of noise is suppressed.

Note that, in order to prevent radiation from colliding with air and scattering, the radiation detector 1 of this embodiment may be operated in vacuum or in a reduced-pressure environment.

### Embodiment 2

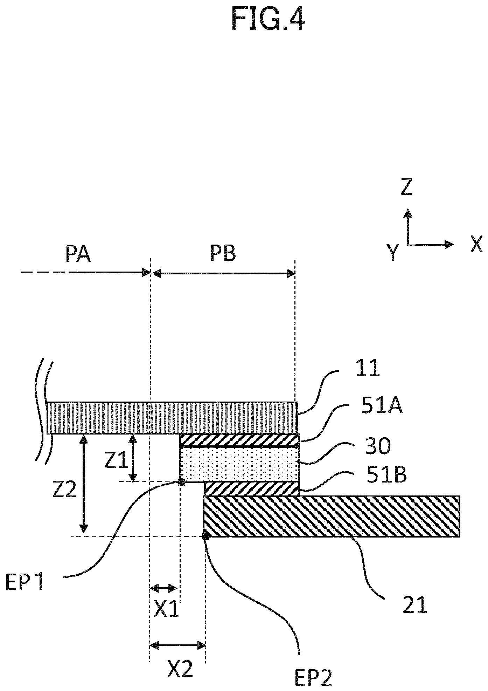

A radiation detector 1 according to Embodiment 2 will be described with reference to FIG. 1A, FIG. 1B, and FIG. 4. In the radiation detector 1 of this embodiment, the appearance in plan view when viewed from the direction in which the radiation is incident is also similar to that in FIG. 1B. FIG. 1A illustrates a cross-section taken along line C-C in FIG. 1B, and FIG. 4 is a partially enlarged view of a right side portion in FIG. 1A. Elements common to the radiation detector 1 according to Embodiment 1 are denoted by the same reference numerals and illustrated, and description thereof will be simplified or omitted.

In this embodiment, in the semiconductor layer 11, when a main surface on a radiation incident side is referred to as a front surface, and a main surface on the opposite side is referred to as a rear surface, a part of the peripheral region PB of the rear surface also faces the first support member 30 in a similar manner as in Embodiment 1. A part of the peripheral region PB faces the second support member 21 with the first support member 30 interposed therebetween.

As illustrated in FIG. 4, the width of the region A0 (the width in the direction parallel to the main surface of the semiconductor layer 11) is set as X1, and the width of the region A2 (the width in the direction parallel to the main surface of the semiconductor layer 11) is set as X2. A distance from the lower surface of the semiconductor layer 11 to the lower surface of the first support member 30 (a distance in a direction orthogonal to the main surface of the semiconductor layer 11) is defined as Z1, and a distance from the lower surface of the semiconductor layer 11 to the lower surface of the second support member 21 (a distance in a direction orthogonal to the main surface of the semiconductor layer 11) is defined as Z2.

As illustrated in FIG. 4, in the first support member 30, a point at which the side surface on the detection region PA side and the lower surface intersect each other is referred to as EP1, and in the second support member 21, a point at which the side surface on the detection region PA side and the lower surface intersect each other is referred to as EP2. When the radiation detector 1 is seen through from a direction orthogonal to an incident surface of the semiconductor layer 11, EP1 is spaced apart from the boundary between the detection region PA and the peripheral region PB by a first distance (X1). In addition, EP2 is spaced apart from the boundary between the detection region PA and the peripheral region PB by a second distance (X2) larger than the first distance.

In this embodiment, a position and a size of each member are set to satisfy the following Conditions 1 and 2. $Z 1 < X 1 / tan \left(10°\right)$ $Z 2 < X 2 / tan \left(10°\right)$

Specifically, for example, X1 is set to 200 µm, Z1 is set to 725 µm, X2 is set to 700 µm, and Z2 is set to 3725 µm. Note that, this is an example, and different numerical values may be used as long as Condition 1 and Condition 2 are satisfied.

When the radiation is incident to the semiconductor layer 11 and is transmitted therethrough, a component scattered in a direction having an angle with respect to the negative Z-direction (incident direction) as illustrated in FIG. 3 exists. For example, in a case where the thickness of the semiconductor layer 11 is 50 µm, the radiation (for example, electron beam) scattered at an angle of 10° or more with respect to the incident direction is approximately 50% or less of the total radiation transmitted through the semiconductor layer 11. In a case of radiation (for example, electron beam) scattered at an angle of 45° or more with respect to the incident direction, the ratio is approximately 10% or less. This embodiment has a configuration in which only radiation scattered at an angle exceeding 10° with respect to the incident direction can collide with the side surfaces of the first support member 30 and the second support member 21.

As described above, since the amount of radiation that can collide with the side surfaces of the first support member 30 and the second support member 21 is limited, the amount of radiation scattered or reflected therefrom again in the direction of the semiconductor layer 11 is small, and generation of noise can be greatly reduced.

### Embodiment 3

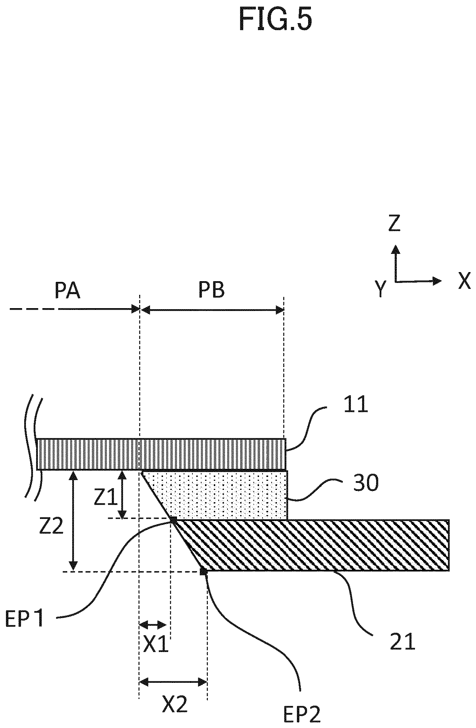

A radiation detector 1 according to Embodiment 3 will be described with reference to FIG. 1B and FIG. 5. In the radiation detector 1 of this embodiment, the appearance in plan view when viewed from the direction in which the radiation is incident is also similar to that in FIG. 1B. FIG. 5 is a partially enlarged view of a right side portion of the cross-section taken along line C-C in FIG. 1B. Elements common to the radiation detector 1 according to Embodiment 1 are denoted by the same reference numerals and illustrated, and description thereof will be simplified or omitted.

In the semiconductor layer 11, when a main surface on a radiation incident side is referred to as a front surface, and a main surface on the opposite side is referred to as a rear surface, the peripheral region PB of the rear surface faces the first support member 30. A part of the peripheral region PB faces the second support member 21 with the first support member 30 interposed therebetween.

In Embodiments 1 and 2, the side surfaces of the first support member 30 and the second support member 21 are surfaces along a direction (Z-direction) orthogonal to the main surface of the semiconductor layer 11. In contrast, in this embodiment, as shown in FIG. 5, the side surfaces of the first support member 30 and the second support member 21 are inclined surfaces inclined with respect to the direction (Z-direction) orthogonal to the main surface of the semiconductor layer 11.

As illustrated in FIG. 5, in the first support member 30, a point at which the side surface (inclined surface) on the detection region PA side and the lower surface intersect each other is referred to as EP1, and in the second support member 21, a point at which the side surface (inclined surface) on the detection region PA side and the lower surface intersect each other is referred to as EP2. When the radiation detector 1 is seen through from a direction orthogonal to an incident surface of the semiconductor layer 11, EP1 is spaced apart from the boundary between the detection region PA and the peripheral region PB by a first distance (X1). In addition, EP2 is spaced apart from the boundary between the detection region PA and the peripheral region PB by a second distance (X2) larger than the first distance. Note that, EP1 is a point farthest from the boundary between the detection region PA and the peripheral region PB on the side surface (inclined surface) of the first support member 30, and EP2 is a point farthest from the boundary between the detection region PA and the peripheral region PB on the side surface (inclined surface) of the second support member 21.

When viewed in a direction parallel to the main surface of the semiconductor layer 11, a distance from the boundary between the detection region PA and the peripheral region PB to EP1 is set as X1, and a distance from the boundary between the detection region PA and the peripheral region PB to EP2 is set as X2. A distance from the lower surface of the semiconductor layer 11 to EP1 (a distance in a direction orthogonal to the main surface of the semiconductor layer 11) is defined as Z1, and a distance from the lower surface of the semiconductor layer 11 to EP2 (a distance in a direction orthogonal to the main surface of the semiconductor layer 11) is defined as Z2.

In this embodiment, a position and a size of each member are set to satisfy the following Conditions 3 and 4. $Z 1 < X 1 / tan \left(10°\right)$ $Z 2 < X 2 / tan \left(10°\right)$

Specifically, for example, X1 is set to 200 µm, Z1 is set to 725 µm, X2 is set to 700 µm, and Z2 is set to 3725 µm. Note that, this is an example, and different numerical values may be used as long as Condition 1 and Condition 2 are satisfied.

As described in Embodiment 2, when the radiation is incident to the semiconductor layer 11 and is transmitted therethrough, a component scattered in a direction having an angle with respect to the negative Z-direction (incident direction) as illustrated in FIG. 3 exists. For example, in a case where the thickness of the semiconductor layer 11 is 50 µm, the radiation (for example, electron beam) scattered at an angle of 10° or more with respect to the incident direction is approximately 50% or less of the total radiation transmitted through the semiconductor layer 11. In a case of radiation (for example, electron beam) scattered at an angle of 45° or more with respect to the incident direction, the ratio is approximately 10% or less. This embodiment has a configuration in which only radiation scattered at an angle exceeding 10° with respect to the incident direction can collide with the side surfaces (inclined surfaces) of the first support member 30 and the second support member 21. As described above, since the amount of radiation that can collide with the end portions (inclined surfaces) of the first support member 30 and the second support member 21 is limited, the amount of radiation scattered or reflected therefrom again in the direction of the semiconductor layer 11 is small, and generation of noise can be greatly reduced.

### Embodiment 4

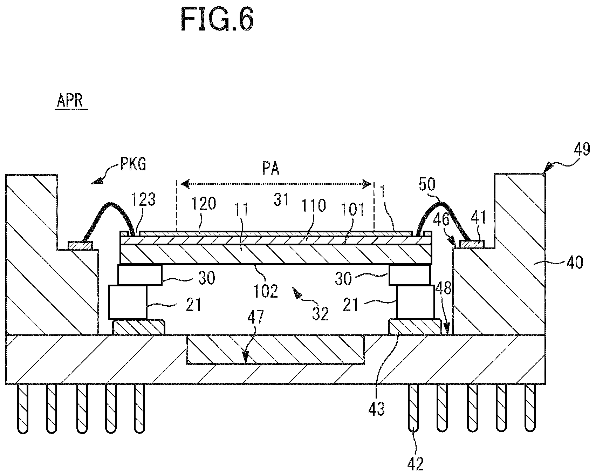

As Embodiment 4, a radiation detection apparatus APR including the radiation detector according to any one of Embodiments 1 to 3 will be described. FIG. 6 is a schematic cross-sectional view of the radiation detection apparatus APR according to Embodiment 4. The radiation detection apparatus APR includes the radiation detector 1 described above and a package PKG that is a container for accommodating the radiation detector 1.

The radiation detector 1 is any of the radiation detectors described in Embodiments 1 to 3, but a protective film 120 is provided on the semiconductor layer 11. The protective film 120 has an opening 123, and is connected to an external electric circuit through the opening 123. In FIG. 6, a wiring structure 110 for reading out electrons accumulated in the photodiode is also schematically illustrated.

The package PKG includes a base body 40, a lid (not illustrated), an internal terminal 41, an external terminal 42, and a bonding material 43. The base body 40 has a recessed shape having a plurality of step portions including a lower step portion 47, a mounting step portion 48, a terminal step portion 46, and an upper step portion 49. The base body 40 is made of, for example, ceramic.

The second support member 21 of the radiation detector 1 is fixed to the mounting step portion 48 by the bonding material 43. Heat generated in the radiation detector 1 is dissipated to the mounting step portion 48 via the first support member 30 and the second support member 21, and is dissipated from the base body 40 to the outside. The radiation detection apparatus APR or an apparatus (described below) including the radiation detection apparatus APR may be configured to forcibly cool the base body 40.

The internal terminal 41 is provided on the terminal step portion 46, and the radiation detector 1 is electrically connected to the internal terminal 41 via a bonding wire 50. The lid (not illustrated) is fixed on an upward side of the upper step portion 49. Note that, the semiconductor layer 11 and the second support member 21 of the radiation detector 1 may be electrically connected by a bonding wire (not illustrated), and the second support member 21 and the internal terminal 41 may be electrically connected by a bonding wire.

The lid (not illustrated) is provided with an opening as a window for transmitting radiation, and the opening is aligned with the detection region PA of the radiation detector 1. Since the radiation emitted to the lid is shielded, only radiation that has transmitted through the opening is emitted to the detection region PA of the radiation detector 1.

A space 31 is formed between the opening and a front surface 101 of the semiconductor layer 11. A space 32 is formed between the lower step portion 47 and a rear surface 102 of the semiconductor layer 11. Since the lower step portion 47 is further recessed as compared with the mounting step portion 48, the space 32 is widened, and a distance between the lower step portion 47 and the rear surface 102 of the semiconductor layer 11 is increased. As a result, the radiation transmitted through the semiconductor layer 11 is prevented from being reflected by the lower step portion 47. The external terminal 42 is preferably a PGA terminal, but may be an LGA terminal that can be attached to a pin type socket.

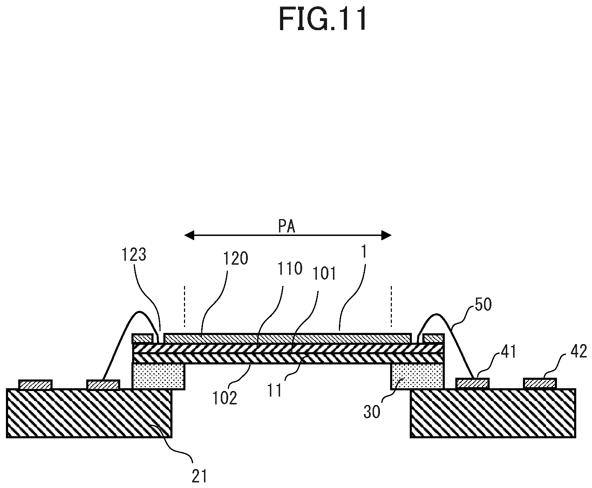

Note that, a modification example of the radiation detection apparatus APR according to this embodiment is illustrated in FIG. 11. In this modification example, the configuration of the support member that supports the radiation detector 1 and the electrical connection method by the bonding wire 50 are changed.

Since in the radiation detection apparatus APR of this embodiment, the amount of radiation that collides with the side surfaces of the first support member 30 and the second support member 21 is limited, the amount of radiation scattered or reflected therefrom in the direction of the semiconductor layer 11 is small, and generation of noise can be greatly reduced.

### Embodiment 5

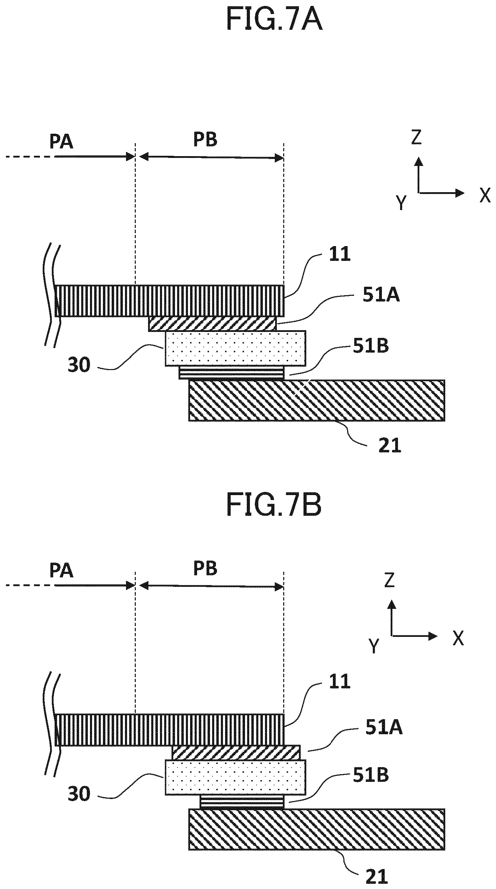

The radiation detector 1 according to Embodiment 5 will be described with reference to FIG. 7A and FIG. 7B. In the radiation detector 1 of this embodiment, the appearance in a plan view when viewed from the direction in which the radiation is incident is also similar to that in FIG. 1B. FIG. 7A and FIG. 7B are partially enlarged views of a right side portion of the cross-section taken along line C-C in FIG. 1B. Elements common to the radiation detector 1 according to Embodiment 1 are denoted by the same reference numerals, and description thereof will be simplified or omitted.

In the semiconductor layer 11, when a main surface on a radiation incident side is referred to as a front surface, and a main surface on the opposite side is referred to as a rear surface, a part of the peripheral region PB of the rear surface faces the first support member 30. A part of the peripheral region PB faces the second support member 21 with the first support member 30 interposed therebetween.

Although not illustrated in FIG. 1A for convenience of illustration, as can be seen with reference to FIG. 7A, in a region where the rear surface of the semiconductor layer 11 and the first support member 30 face each other, these members are bonded by an adhesive layer 51A. In a region where the first support member 30 and the second support member 21 face each other, the first support member 30 and the second support member 21 are bonded to each other by an adhesive layer 51B. For the adhesive layer 51A and the adhesive layer 51B, adhesive is used, but a die attach film (DAF), a double-sided tape, or the like may be used in some cases.

In this embodiment, as shown in FIG. 7A, an end face of the first support member 30 on the detection region PA side is offset toward a side of the peripheral region (PB side) from the boundary between the detection region PA and the peripheral region PB. In addition, an end face of the adhesive layer 51A on the detection region PA side is also offset toward the side of the peripheral region (PB side) from the boundary between the detection region PA and the peripheral region PB. That is, when the semiconductor layer 11 is seen through from the front surface side along a direction (Z-direction) orthogonal to the main surface, the end face of the adhesive layer 51A is located on the peripheral region PB side from the boundary between the detection region PA and the peripheral region PB. Since the adhesive layer 51A is an adhesive layer between the semiconductor layer 11 and the first support member 30, it is preferable that the adhesive layer adheres to at least one of the semiconductor layer 11 and the first support member 30, and it is not preferable that the adhesive layer protrudes from both end faces of the semiconductor layer 11 and the first support member 30.

In addition, an end face of the second support member 21 on the detection region PA side is offset toward a side of the peripheral region (PB side) from the boundary between the detection region PA and the peripheral region PB. In addition, an end face of the adhesive layer 51B on the detection region PA side is offset toward the side of the peripheral region (PB side) from the boundary between the detection region PA and the peripheral region PB in a similar manner as in the adhesive layer 51A. That is, when the semiconductor layer 11 is seen through from the front surface side along a direction (Z-direction) orthogonal to the main surface, the end face of the adhesive layer 51B is located on the peripheral region PB side from the boundary between the detection region PA and the peripheral region PB. Since the adhesive layer 51B is an adhesive layer between the first support member 30 and the second support member 21, it is preferable that the adhesive layer adheres to at least one of the first support member 30 and the second support member 21, and it is not preferable that the adhesive layer protrudes from both end faces of the first support member 30 and the second support member 21.

As shown in FIG. 7B, it is more preferable that the end face of the adhesive layer 51A on the detection region PA side is offset to the opposite side of the detection region PA as compared with the end face of the first support member 30 on the detection region PA side, since the adhesive layer adheres to both the semiconductor layer 11 and the first support member 30. In a case where the peripheral region PB of the semiconductor layer 11 is thinned, the end face of the first support member 30 on a side opposite to the detection region PA is located outside the end face of the semiconductor layer 11. It is preferable that the end face of the adhesive layer 51A on a side opposite to the detection region PA is located outside the end face of the semiconductor layer 11, since the semiconductor layer 11 does not have an eaves shape and is less likely to breakage. The end face of the adhesive layer 51A on a side opposite to the detection region PA is located outside the end face of the semiconductor layer 11. It is more preferable that the end face is closer to the detection region PA as compared with the end face of the first support member 30 on a side opposite to the detection region PA, since the semiconductor layer 11 does not have an eaves shape, and the adhesive layer 51A is fixed to the first support member 30. It is preferable that the end face of the adhesive layer 51B on the detection region PA side is offset to the opposite side of the detection region PA as compared with the end face of the second support member 21 of the detection region PA side, since the adhesive layer 51B is bonded to both the first support member 30 and the second support member 21. In addition, it is preferable that the end face of the adhesive layer 51B on a side opposite to the detection region PA side is offset toward the detection region PA as compared with the end face of the first support member 30 on a side opposite to the detection region PA side, since the adhesive layer is bonded to both the first support member 30 and the second support member 21.

### Embodiment 6

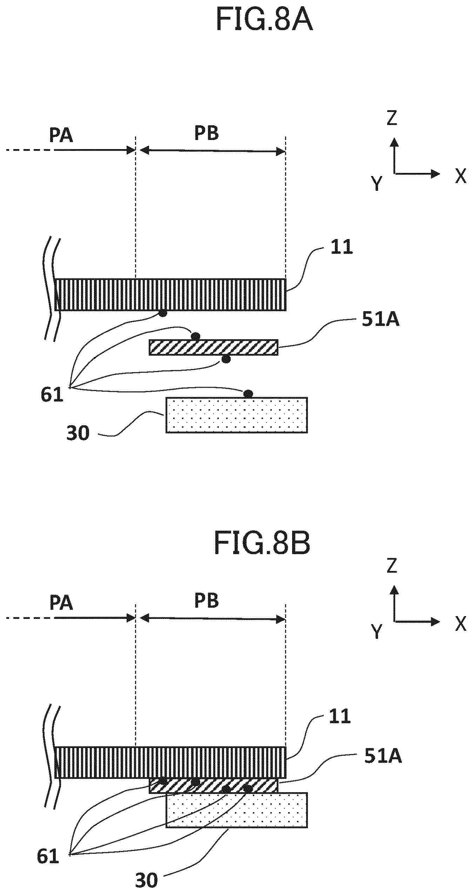

A radiation detector 1 according to Embodiment 6 will be described with reference to FIG. 8A and FIG. 8B. In the radiation detector 1 of this embodiment, the appearance in a plan view when viewed from the direction in which the radiation is incident is also similar to that in FIG. 1B. FIG. 8A and FIG. 8B are partially enlarged views of a right side portion of the cross-section taken along line C-C in FIG. 1B. Elements common to the radiation detector 1 according to Embodiment 1 are denoted by the same reference numerals, and description thereof will be simplified or omitted.

In the semiconductor layer 11, when a main surface on a radiation incident side is referred to as a front surface, and a main surface on the opposite side is referred to as a rear surface, a part of the peripheral region PB of the rear surface faces the first support member 30. A part of the peripheral region PB faces the second support member 21 with the first support member 30 interposed therebetween.

Although not illustrated in FIG. 1A for convenience of illustration, as can be seen with reference to FIG. 8A schematically illustrating a state before bonding, in a region where the rear surface of the semiconductor layer 11 and the first support member 30 face each other, these members are bonded by the adhesive layer 51A. In a region where the first support member 30 and the second support member 21 face each other, the first support member 30 and the second support member 21 are bonded to each other by an adhesive layer 51B. For the adhesive layer 51A and the adhesive layer 51B, adhesive is used, but a die attach film (DAF), a double-sided tape, or the like may be used in some cases.

As shown in FIG. 8A, it is assumed that foreign substances adhere to the adhesive surfaces of the semiconductor layer 11, the adhesive layer 51A, and the first support member 30 before bonding. The foreign substances are sandwiched between the semiconductor layer 11 and the first support member 30, and the adhesive layer 51A is deformed by the foreign substances when the semiconductor layer 11 and the first support member 30 are bonded by the adhesive layer 51A. As illustrated in FIG. 8B, foreign substances having a thickness of approximately half or less of the thickness of the adhesive layer can be contained in the adhesive layer 51A when using adhesive, a DAF, or a double-sided tape that is flexible before being cured as the adhesive layer 51A. At this time, the adhesive surfaces of the semiconductor layer 11 and the first support member 30 are bonded so as to maintain a flat surface.

In a case where the adhesive layer 51A is thermosetting adhesive, the adhesive layer 51A bonded in the above-described state is thermally cured, but the semiconductor layer 11 maintains a flat surface instead of following the shape of the foreign substances. Even though foreign substances are present, since deformation of the thinned semiconductor layer 11 is suppressed, breakage to the semiconductor layer 11 can be suppressed.

In a case where non-flexible adhesive, a non-flexible DAF, and a non-flexible double-sided tape are used as the adhesive layer 51A, since the semiconductor layer 11 tends to follow the shape of the foreign substances, the flat surface cannot be maintained. That is, since the thinned semiconductor layer 11 is deformed in conformity to the adhesive layer 51A, a chip is to breakage.

Although the semiconductor layer 11, the adhesive layer 51A, and the first support member 30 have been described, the same shall apply to the first support member 30, the adhesive layer 51B, and the second support member 21.

### Embodiment 7

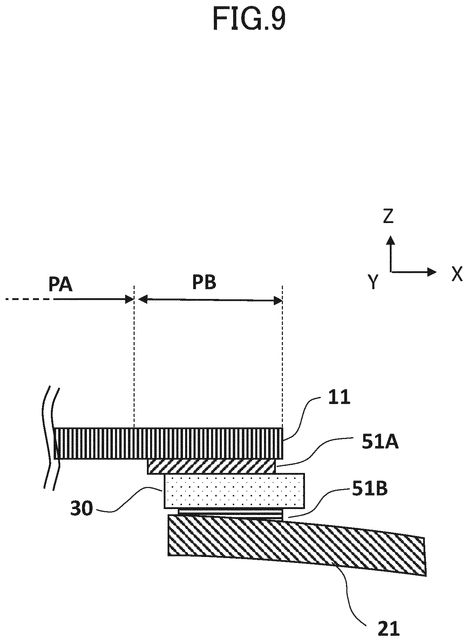

A radiation detector 1 according to Embodiment 7 will be described with reference to FIG. 9. In the radiation detector 1 of this embodiment, the appearance in a plan view when viewed from the direction in which the radiation is incident is also similar to that in FIG. 1B. FIG. 9 is a partially enlarged view of a right side portion of the cross-section taken along line C-C in FIG. 1B. Elements common to the radiation detector 1 according to Embodiment 1 are denoted by the same reference numerals, and description thereof will be simplified or omitted.

In the semiconductor layer 11, when a main surface on a radiation incident side is referred to as a front surface, and a main surface on the opposite side is referred to as a rear surface, a part of the peripheral region PB of the rear surface faces the first support member 30. A part of the peripheral region PB faces the second support member 21 with the first support member 30 interposed therebetween.

Although not illustrated in FIG. 1A for convenience of illustration, as can be seen with reference to FIG. 9, in a region where the rear surface of the semiconductor layer 11 and first support member 30 face each other, these members are bonded by the adhesive layer 51A. In a region where the first support member 30 and the second support member 21 face each other, the first support member 30 and the second support member 21 are bonded to each other by an adhesive layer 51B. For the adhesive layer 51A and the adhesive layer 51B, adhesive is used, but a die attach film (DAF), a double-sided tape, or the like may be used in some cases.

The second support member 21 is a circuit substrate electrically connected to the semiconductor layer 11. As the circuit substrate, a substrate mainly made of a resin such as a glass epoxy substrate, or a substrate mainly made of ceramic such as an alumina substrate is used. These substrates are inferior in flatness compared to semiconductor substrates.

In a case where the flatness of the second support member 21 is half or less of the thickness of the adhesive layer 51B, and the first support member 30 is flat, adhesive that is flexible before curing, such as thermosetting adhesive, a DAF that is flexible, a double-sided tape that is flexible or the like may be used. Thus, the adhesive can be applied in conformity to the shapes of the first support member 30 and the second support member 21. At this time, in a case of the adhesive, the adhesive layer 51B may be cured as it is, and in a case of the thermosetting DAF, the adhesive layer 51B may also be cured as it is. In a case of the double-sided tape, when bonding the tape by applying a load larger than a load with which the tape is plastically deformed, the tape can be made to follow the shape of the substrate, a stress on the first support member 30 can be mitigated, and deformation of the semiconductor layer 11 can also be suppressed.

### Embodiment 8

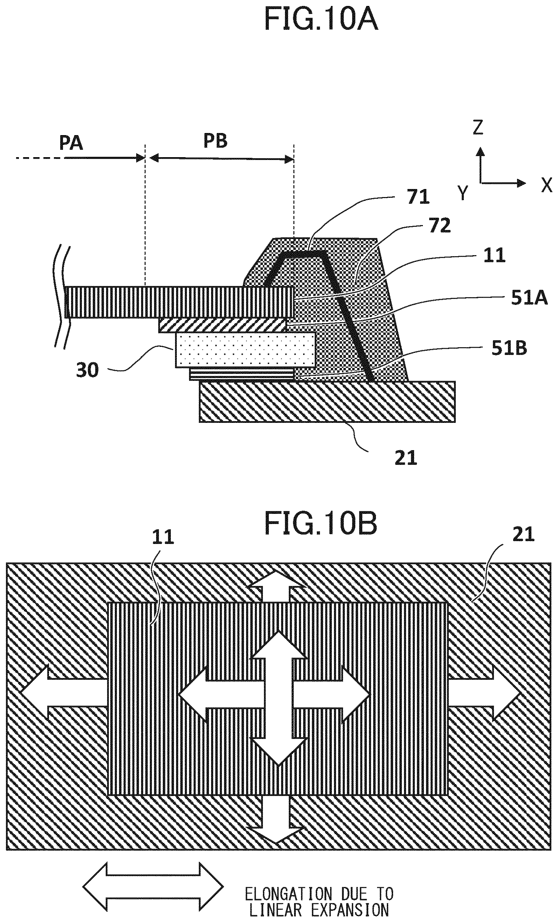

A radiation detector 1 according to Embodiment 8 will be described with reference to FIG. 10A. In the radiation detector 1 of this embodiment, the appearance in a plan view when viewed from the direction in which the radiation is incident is also similar to that in FIG. 1B. FIG. 10A is a partially enlarged view of a right side portion of the cross-section taken along line C-C in FIG. 1B. Elements common to the radiation detector 1 according to Embodiment 1 are denoted by the same reference numerals, and description thereof will be simplified or omitted.

In the semiconductor layer 11, when a main surface on a radiation incident side is referred to as a front surface, and a main surface on the opposite side is referred to as a rear surface, a part of the peripheral region PB of the rear surface faces the first support member 30. A part of the peripheral region PB faces the second support member 21 with the first support member 30 interposed therebetween.

Although not illustrated in FIG. 1A for convenience of illustration, as can be seen with reference to FIG. 10A, in a region where the rear surface of the semiconductor layer 11 and the first support member 30 face each other, these members are bonded by the adhesive layer 51A. In a region where the first support member 30 and the second support member 21 face each other, the first support member 30 and the second support member 21 are bonded to each other by an adhesive layer 51B. For the adhesive layer 51A and the adhesive layer 51B, adhesive is used, but a die attach film (DAF), a double-sided tape, or the like may be used in some cases.

The second support member 21 is a circuit substrate electrically connected to the semiconductor layer 11 by a wire 71. The wire 71 is embedded in a protective resin 72 in order to protect the wire from deformation at the time of contact or the like.

In this embodiment, the first support member 30 and the second support member 21 are bonded by the adhesive layer 51B which is flexible adhesive, a flexible DAF, a flexible double-sided tape, or the like. In addition, the protective resin 72 is a flexible resin for suppressing deformation of the wire 71 even when an external object comes into contact with the protective resin. The semiconductor layer 11 and the first support member 30 are bonded to each other by the adhesive layer 51A that is cured. The semiconductor layer 11 and the first support member 30 are made of a metal such as Si, and the second support member 21 may be a general-purpose resin substrate or ceramic substrate whose linear expansion is not reduced. In this case, as shown in the schematic plan view of FIG. 10B, in a temperature environment higher than that at the time of bonding, elongation due to linear expansion is larger in the second support member 21, and is smaller in the semiconductor layer 11 and the first support member 30. When the temperature environment is lower than that at the time of bonding, shrinkage is larger in the second support member 21, and is smaller in the semiconductor layer 11 and the first support member 30. Since the radiation detector 1 is used in various temperature bands such as a lowtemperature environment and a high-temperature environment, a stress caused by a linear expansion difference is applied between the semiconductor layer 11, the first support member 30, and the second support member 21 due to a variation in temperature. In this embodiment, since the adhesive layer 51B and the protective resin 72 are flexible, the adhesive layer 51B and the protective resin 72 can absorb the stress caused by the difference in linear expansion coefficient.

Consequently, since the deformation of the first support member 30 is suppressed, and the deformation of the semiconductor layer 11 is suppressed, breakage due to the deformation of the semiconductor layer 11 can be prevented.

### Embodiment 9

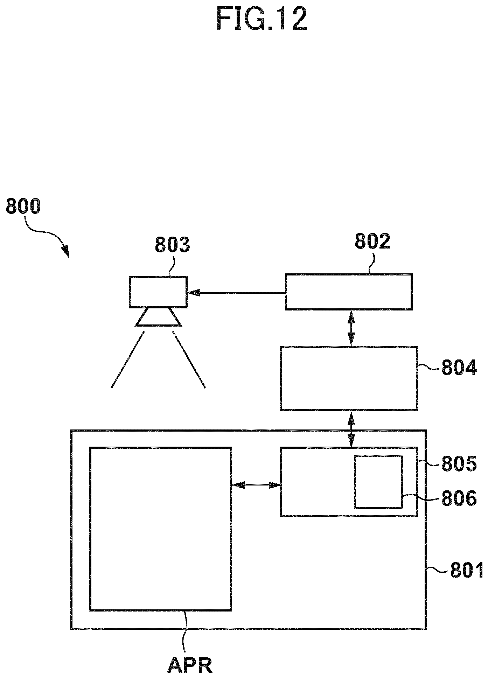

A radiation imaging apparatus 801 in which the radiation detection apparatus APR according to Embodiment 4 described above is incorporated, and a radiation imaging system 800 using the radiation imaging apparatus will be described with reference to FIG. 12.

The radiation imaging system 800 is configured to electrically capture an optical image formed by radiation to obtain an electrical radiation image (that is, radiation image data). The radiation imaging system 800 includes, for example, the radiation imaging apparatus 801, an irradiation control unit 802, a radiation source 803, and a computer 804. The radiation imaging system 800 can display a captured radiation image on a display apparatus (not illustrated) or transmit radiation image data to the outside via a communication device (not illustrated). The radiation imaging system 800 can be suitably used in fields such as medical image diagnosis and non-destructive inspection.

The radiation source 803 for irradiation with the radiation initiates irradiation with the radiation in accordance with an exposure command from the irradiation control unit 802. The radiation emitted from the radiation source 803 is emitted to the radiation imaging apparatus 801 through a subject (not illustrated). The radiation source 803 stops emitting radiation in accordance with a stop command from the irradiation control unit 802.

The radiation imaging apparatus 801 includes the radiation detection apparatus APR according to Embodiment 4 described above, a control unit 805 that controls the radiation detection apparatus APR, and a signal processing unit 806 that processes a signal output from the radiation detection apparatus APR.

For example, in a case where a signal output from the radiation detection apparatus APR is an analog signal, the signal processing unit 806 can perform A/D conversion on the analog signal and output the resultant signal to the computer 804 as radiation image data. In addition, the signal processing unit 806 may generate a stop signal for stopping irradiation with radiation from the radiation source 803, for example, on the basis of a signal output from the radiation detection apparatus APR. The stop signal is supplied to the irradiation control unit 802 via the computer 804, and the irradiation control unit 802 transmits a stop command to the radiation source 803 in response to the stop signal.

The control unit 805 may be configured by, for example, a programmable logic device (PLD) such as a field programmable gate array (FPGA). Alternatively, the control unit 805 may also be configured by an application specific integrated circuit (ASIC) or a general-purpose computer in which a program is incorporated. Furthermore, the control unit 805 may be configured by a combination of all or a part described above.

Furthermore, although the signal processing unit 806 is illustrated as being disposed in the control unit 805 or being a part of the function of the control unit 805, the technology is not limited thereto. The control unit 805 and the signal processing unit 806 may be configured separately. Furthermore, the signal processing unit 806 may be disposed separately from the radiation imaging apparatus 801. For example, the computer 804 may have the function of the signal processing unit 806. Therefore, the signal processing unit 806 may be included in the radiation imaging system 800 as a signal processing device that processes a signal output from the radiation imaging apparatus 801.

The computer 804 can perform control of the radiation imaging apparatus 801 and the irradiation control unit 802, and processing for receiving radiation image data from the radiation imaging apparatus 801 and displaying the radiation image data as a radiation image. In addition, the computer 804 can function as an input portion for a user to input conditions for capturing a radiation image.

As an example of the sequence, the irradiation control unit 802 includes an exposure switch, and when the exposure switch is turned on by the user, the irradiation control unit transmits an exposure command to the radiation source 803 and also transmits a start notification indicating the start of radiation emission to the computer 804. The computer 804 that has received the start notification notifies the control unit 805 of the radiation imaging apparatus 801 of the start of irradiation with radiation in response to the start notification. In response to this, the control unit 805 causes the radiation detection apparatus APR to generate a signal corresponding to incident radiation.

The radiation imaging apparatus of this embodiment and the radiation imaging system using the radiation imaging apparatus detect radiation by using the radiation detection apparatus APR according to Embodiment 4. Since in the radiation detection apparatus APR, the amount of radiation that collides with the side surfaces of the first support member 30 and the second support member 21 is limited, the amount of radiation scattered or reflected therefrom in the direction of the semiconductor layer 11 is small, and generation of noise can be greatly reduced. That is, it is possible to capture an extremely high-quality radiation image.

### Embodiment 10

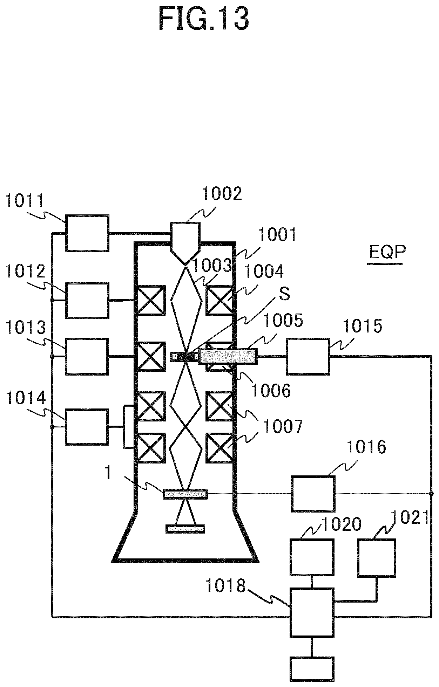

A transmission electron microscope (TEM) system will be described as a radiation imaging system in which the radiation detector 1 according to any one of Embodiments 1 to 8 described above is incorporated. FIG. 13 is a schematic diagram illustrating a schematic configuration of the transmission electron microscope (TEM) system according to this embodiment.

Equipment EQP as a transmission electron microscope includes an electron beam source 1002 (electron gun), an irradiation lens 1004, a vacuum chamber 1001 (lens barrel), an objective lens 1006, a magnifying lens system 1007, and the radiation detector 1 according to any one of Embodiments 1 to 8.

An electron beam 1003, which is radiation emitted from the electron beam source 1002 (electron gun) as a radiation source, is focused by the irradiation lens 1004 and is emitted to a sample S as an analysis objective held in a sample holder. A space through which the electron beam 1003 passes is defined by the vacuum chamber 1001 (lens barrel) included in the equipment EQP, and this space is held in vacuum.

The electron beam 1003 transmitted through the sample S is magnified by the objective lens 1006 and the magnifying lens system 1007, and is imaged on the light receiving surface of the radiation detector 1. An electron optical system for irradiating the sample S with an electron beam is referred to as an irradiation optical system, and an electron optical system for forming an image of the electron beam transmitted through the sample S on a light-receiving surface (detection region PA) of the radiation detector 1 is referred to as an imaging optical system.

The electron beam source 1002 is controlled by an electron beam source control device 1011. The irradiation lens 1004 is controlled by the irradiation lens control device 1012. The objective lens 1006 is controlled by an objective lens control device 1013. The magnifying lens system 1007 is controlled by a magnifying lens system control device 1014. A control mechanism 1005 of the sample holder is controlled by a holder control device 1015 that controls a driving mechanism of the sample holder.

The electron beam 1003 transmitted through the sample S is detected by the radiation detector 1. The output signal from the radiation detector 1 is processed by the signal processing device 1016 and the image processing device 1018 to generate an image signal. The generated image signal (transmission electron image) is displayed on an image display monitor 1020 and an analysis monitor 1021 as display apparatuses.

In the transmission electron microscope (TEM) system of this embodiment which includes the radiation detector 1 according to any one of Embodiments 1 to 8, the amount of radiation colliding with the side end faces of the first support member 30 and the second support member 21 of the radiation detector 1 is limited. Therefore, the amount of radiation scattered or reflected therefrom in the direction of the semiconductor layer 11 is small, and the generation of noise can be greatly reduced. That is, it is possible to capture an extremely high-quality radiation image.

Note that, the electron microscope according to the embodiment is not limited to the exemplified transmission electron microscope (TEM), and may be, for example, a scanning electron microscope (SEM) or a scanning transmission electron microscope (STEM). Furthermore, for example, an electron microscope having a processing function such as ion beam milling or ion beam induced deposition (IBID), or a dual-beam electron microscope including a focused ion beam (FIB) such as FIB-SEM may be used.

### Other Embodiments

Note that, the technology is not limited to the embodiments described above, and many modifications can be made within the technical concept of the technology. For example, all or some of the different embodiments described above may be combined and implemented.

In Embodiments 1 and 2, the side surfaces of the first support member 30 and the second support member 21 are orthogonal to the main surface of the semiconductor layer 11. In addition, in Embodiment 3, the side surfaces of the first support member 30 and the second support member 21 are inclined with respect to the direction orthogonal to the main surface of the semiconductor layer 11.

However, the combination of the first support member 30 and the second support member 21 is not limited to these embodiments. For example, the side surface of the first support member 30 may be orthogonal to the main surface of the semiconductor layer 11, and the side surface of the second support member 21 may be inclined with respect to the direction orthogonal to the main surface of the semiconductor layer 11. Alternatively, the side surface of the first support member 30 may be inclined with respect to the direction orthogonal to the main surface of the semiconductor layer 11, and the side surface of the second support member 21 may be orthogonal to the main surface of the semiconductor layer 11.

As Embodiment 4, the radiation detection apparatus APR including the radiation detector according to any one of Embodiments 1 to 3 has been described, but the radiation detection apparatus APR may include the radiation detector according to any one of Embodiments 5 to 8.

According to the technology, since it is possible to reduce the radiation scattered when passing through the semiconductor layer from being scattered or reflected again by a surrounding member arranged at a region other than immediately below the detection unit and returning to the semiconductor layer, it is possible to provide a radiation detector capable of obtaining a radiation image with high image quality.

## Claims

1. A radiation detector, comprising:
a semiconductor layer (11) including a detection region (PA) provided with a radiation detection element and a peripheral region (PB) provided outside the detection region (PA), the peripheral region (PB) including a circuit;
a first support member (30) configured to support at least a part of the peripheral region (PB) in a surface of the semiconductor layer (11) on a side opposite to an incident surface on which the radiation is incident; and
a second support member (21) configured to support a part of the first support member (30) from a side opposite to the semiconductor layer (11),
wherein a point at which a side surface on a side of the detection region (PA) of the first support member (30) and a lower surface of the first support member (30) intersect each other is defined as EP1, and
a point at which a side surface on the side of the detection region side of the second support member (21) and a lower surface of the second support member (21) intersect each other is defined as EP2, and
in a case where the radiation detector is seen through from a direction orthogonal to the incident surface,
the EP1 is spaced apart from a boundary between the detection region (PA) and the peripheral region (PB) by a first distance (A0), the boundary being disposed between the EP1 and the detection region (PA), and
the EP2 is spaced apart from the boundary between the detection region (PA) and the peripheral region (PB) by a second distance (A2) larger than the first distance (A0), and
a part of the second support member (21) and the peripheral region (PB) are overlapping each other.

2. The radiation detector according to claim 1,
wherein in a case where the first distance is set as X1, the second distance is set as X2, a distance between the surface of the semiconductor layer (11) on a side opposite to the incident surface and the EP1 is set as Z1, and a distance between the surface of the semiconductor layer (11) on a side opposite to the incident surface and the EP2 is set as Z2,
relationships of Z1 < X1/tan (10°) and Z2 < X2/tan (10°) are satisfied.

3. The radiation detector according to claim 1 or 2,
wherein in a case where the radiation detector (1) is seen through from the direction orthogonal to the incident surface,
a first region (A0) in which the semiconductor layer (11) does not overlap any of the first support member (30) and the second support member (21) is provided on a side of the peripheral region (PB) adjacent to the boundary between the detection region (PA) and the peripheral region (PB).

4. The radiation detector according to claim 3,
wherein in a case where the radiation detector (1) is seen through from the direction orthogonal to the incident surface,
a second region (A1) in which the semiconductor layer (11) overlaps the first support member (30) but does not overlap the second support member (21) is provided outside the first region (A0).

5. The radiation detector according to claim 4,
wherein in a case where the radiation detector (1) is seen through from the direction orthogonal to the incident surface,
a third region (A3) in which the semiconductor layer (11) overlaps the first support member (30) and the second support member (21) is provided outside the second region (A1).

6. The radiation detector according to claim 4 or 5,
wherein in a case where the radiation detector (1) is seen through from the direction orthogonal to the incident surface,
a width of the first region (A0) is the first distance, and a width of the second region (A1) is the second distance.

7. The radiation detector according to any one of claims 1 to 6,
wherein in a cross section in the direction orthogonal to the incident surface,
an end portion of the first support member (30) includes a first inclined surface inclined with respect to the direction orthogonal to the incident surface, and the first inclined surface is inclined in a direction away from the boundary between the detection region (PA) and the peripheral region (PB) as being spaced apart from the semiconductor layer (11).

8. The radiation detector according to claim 7,
wherein the first inclined surface is inclined by an angle larger than 10° with respect to the direction orthogonal to the incident surface.

9. The radiation detector according to any one of claims 1 to 8,
wherein in the cross section in the direction orthogonal to the incident surface,
an end portion of the second support member (21) includes a second inclined surface inclined with respect to the direction orthogonal to the incident surface, and the second inclined surface is inclined in a direction away from the boundary between the detection region (PA) and the peripheral region (PB) as being spaced apart from the semiconductor layer (11).

10. The radiation detector according to claim 9,
wherein the second inclined surface is inclined by an angle larger than 10° with respect to the direction orthogonal to the incident surface.

11. The radiation detector according to any one of claims 1 to 10,
wherein the semiconductor layer (11) is provided with a signal processing circuit in the peripheral region (PB).

12. The radiation detector according to any one of claims 1 to 11,
wherein the semiconductor layer (11) and the first support member (30) are connected to each other via an adhesive layer (51A).

13. The radiation detector according to any one of claims 1 to 12,
wherein the first support member (30) and the second support member (21) are connected to each other via an adhesive layer (51B).

14. A radiation imaging system, comprising:
the radiation detector (1) according to any one of claims 1 to 13; and
a signal processing unit (806) configured to process a signal output from the radiation detector.

15. A radiation imaging system, comprising:
a radiation source (803) configured to emit radiation, and
the radiation detector (1) according to any one of claims 1 to 13,
wherein the detection region is configured to be irradiated by the radiation.

## Patentansprüche

1. Strahlungsdetektor, umfassend:
eine Halbleiterschicht (11), die einen Detektionsbereich (PA), der mit einem Strahlungsdetektionselement versehen ist, und einen Randbereich (PB), der außerhalb des Detektionsbereichs (PA) vorgesehen ist, enthält, wobei der Randbereich (PB) eine Schaltung enthält;
ein erstes Trägerelement (30), das konfiguriert ist, mindestens einen Teil des Randbereichs (PB) in einer Fläche der Halbleiterschicht (11) auf einer Seite gegenüber einer Einfallsfläche, auf die die Strahlung einfällt, zu tragen; und
ein zweites Trägerelement (21), das konfiguriert ist, einen Teil des ersten Trägerelements (30) von einer Seite gegenüber der Halbleiterschicht (11) zu tragen,
wobei ein Punkt, an dem eine Seitenfläche auf einer Seite des Detektionsbereichs (PA) des ersten Trägerelements (30) und eine untere Fläche des ersten Trägerelements (30) einander schneiden, als EP1 definiert ist, und
ein Punkt, an dem eine Seitenfläche auf der Seite der Detektionsbereichsseite des zweiten Trägerelements (21) und eine untere Fläche des zweiten Trägerelements (21) einander schneiden, als EP2 definiert ist, und
in einem Fall, in dem der Strahlungsdetektor aus einer Richtung senkrecht zur Einfallsfläche sichtbar ist,
EP1 von einer Grenze zwischen dem Detektionsbereich (PA) und dem Randbereich (PB) um einen ersten Abstand (A0) beabstandet ist, wobei sich die Grenze zwischen EP1 und dem Detektionsbereich (PA) befindet, und
EP2 von der Grenze zwischen dem Detektionsbereich (PA) und dem Randbereich (PB) um einen zweiten Abstand (A2), der größer als der erste Abstand (A0) ist, beabstandet ist, und
ein Teil des zweiten Trägerelements (21) und der Randbereich (PB) einander überlappen.

2. Strahlungsdetektor nach Anspruch 1,
wobei in einem Fall, in dem der erste Abstand als X1 festgelegt ist, der zweite Abstand als X2 festgelegt ist, ein Abstand zwischen der Fläche der Halbleiterschicht (11) auf einer Seite gegenüber der Einfallsfläche und EP1 als Z1 festgelegt ist und ein Abstand zwischen der Fläche der Halbleiterschicht (11) auf einer Seite gegenüber der Einfallsfläche und EP2 als Z2 festgelegt ist,
Beziehungen von Z1 < X1/tan (10°) und Z2 < X2/tan (10°) erfüllt werden.

3. Strahlungsdetektor nach Anspruch 1 oder 2,
wobei in einem Fall, in dem der Strahlungsdetektor (1) aus der Richtung senkrecht zur Einfallsfläche sichtbar ist,
ein erster Bereich (A0), in dem die Halbleiterschicht (11) weder das erste Trägerelement (30) noch das zweite Trägerelement (21) überlappt, auf einer Seite des Randbereichs (PB) benachbart zur Grenze zwischen dem Detektionsbereich (PA) und dem Randbereich (PB) vorgesehen ist.

4. Strahlungsdetektor nach Anspruch 3,
wobei in einem Fall, in dem der Strahlungsdetektor (1) aus der Richtung senkrecht zur Einfallsfläche sichtbar ist,
ein zweiter Bereich (A1), in dem die Halbleiterschicht (11) das erste Trägerelement (30) überlappt, aber das zweite Trägerelement (21) nicht überlappt, außerhalb des ersten Bereichs (A0) vorgesehen ist.

5. Strahlungsdetektor nach Anspruch 4,
wobei in einem Fall, in dem der Strahlungsdetektor (1) aus der Richtung senkrecht zur Einfallsfläche sichtbar ist,
ein dritter Bereich (A3), in dem die Halbleiterschicht (11) das erste Trägerelement (30) und das zweite Trägerelement (21) überlappt, außerhalb des zweiten Bereichs (A1) vorgesehen ist.

6. Strahlungsdetektor nach Anspruch 4 oder 5,
wobei in einem Fall, in dem der Strahlungsdetektor (1) aus der Richtung senkrecht zur Einfallsfläche sichtbar ist,
eine Breite des ersten Bereichs (A0) der erste Abstand ist und eine Breite des zweiten Bereichs (A1) der zweite Abstand ist.

7. Strahlungsdetektor nach einem der Ansprüche 1 bis 6,
wobei in einem Querschnitt in der Richtung senkrecht zur Einfallsfläche,
ein Endabschnitt des ersten Trägerelements (30) eine erste geneigte Fläche enthält, die in Bezug auf die Richtung senkrecht zur Einfallsfläche geneigt ist, und die erste geneigte Fläche in einer Richtung weg von der Grenze zwischen dem Detektionsbereich (PA) und dem Randbereich (PB) geneigt ist, während sie von der Halbleiterschicht (11) beabstandet ist.

8. Strahlungsdetektor nach Anspruch 7,
wobei die erste geneigte Fläche um einen Winkel größer als 10° in Bezug auf die Richtung senkrecht zur Einfallsfläche geneigt ist.

9. Strahlungsdetektor nach einem der Ansprüche 1 bis 8,
wobei im Querschnitt in der Richtung senkrecht zur Einfallsfläche,
ein Endabschnitt des zweiten Trägerelements (21) eine zweite geneigte Fläche enthält, die in Bezug auf die Richtung senkrecht zur Einfallsfläche geneigt ist, und die zweite geneigte Fläche in einer Richtung weg von der Grenze zwischen dem Detektionsbereich (PA) und dem Randbereich (PB) geneigt ist, während sie von der Halbleiterschicht (11) beabstandet ist.

10. Strahlungsdetektor nach Anspruch 9,
wobei die zweite geneigte Fläche um einen Winkel größer als 10° in Bezug auf die Richtung senkrecht zur Einfallsfläche geneigt ist.

11. Strahlungsdetektor nach einem der Ansprüche 1 bis 10,
wobei die Halbleiterschicht (11) im Randbereich (PB) mit einer Signalverarbeitungsschaltung versehen ist.

12. Strahlungsdetektor nach einem der Ansprüche 1 bis 11,
wobei die Halbleiterschicht (11) und das erste Trägerelement (30) über eine Haftschicht (51A) miteinander verbunden sind.

13. Strahlungsdetektor nach einem der Ansprüche 1 bis 12,
wobei das erste Trägerelement (30) und das zweite Trägerelement (21) über eine Haftschicht (51B) miteinander verbunden sind.

14. Strahlungsbildgebungssystem, umfassend:
den Strahlungsdetektor (1) nach einem der Ansprüche 1 bis 13; und
eine Signalverarbeitungseinheit (806), die konfiguriert ist, ein vom Strahlungsdetektor ausgegebenes Signal zu verarbeiten.

15. Strahlungsbildgebungssystem, umfassend:
eine Strahlungsquelle (803), die konfiguriert ist, Strahlung zu emittieren, und
den Strahlungsdetektor (1) nach einem der Ansprüche 1 bis 13,
wobei der Detektionsbereich konfiguriert ist, von der Strahlung bestrahlt zu werden.

## Revendications

1. Détecteur de rayonnement, comprenant :
une couche semi-conductrice (11) comportant une région de détection (PA) munie d'un élément de détection de rayonnement et une région périphérique (PB) prévue à l'extérieur de la région de détection (PA), la région périphérique (PB) comportant un circuit ;
un premier organe de support (30) configuré pour supporter au moins une partie de la région périphérique (PB) dans une surface de la couche semi-conductrice (11) sur un côté opposé à une surface incidente sur laquelle le rayonnement est incident ; et
un second organe de support (21) configuré pour supporter une partie du premier organe de support (30) à partir d'un côté opposé à la couche semi-conductrice (11),
dans lequel un point auquel une surface latérale sur un côté de la région de détection (PA) du premier organe de support (30) et une surface inférieure du premier organe de support (30) se croisent est défini comme EP1, et
un point auquel une surface latérale sur le côté du côté de région de détection du second organe de support (21) et une surface inférieure du second organe de support (21) se croisent est défini comme EP2, et
dans un cas où le détecteur de rayonnement est observé à partir d'une direction orthogonale à la surface incidente, l'EP1 est espacé d'une limite entre la région de détection (PA) et la région périphérique (PB) d'une première distance (A0), la limite étant disposée entre l'EP1 et la région de détection (PA), et
l'EP2 est espacé de la limite entre la région de détection (PA) et la région périphérique (PB) d'une seconde distance (A2) supérieure à la première distance (A0), et
une partie du second organe de support (21) et la région périphérique (PB) se chevauchent.

2. Détecteur de rayonnement selon la revendication 1,
dans lequel dans un cas où la première distance est définie comme X1, la seconde distance est définie comme X2, une distance entre la surface de la couche semi-conductrice (11) sur un côté opposé à la surface incidente et l'EP1 est définie comme Z1, et une distance entre la surface de la couche semi-conductrice (11) sur un côté opposé à la surface incident et l'EP2 est définie comme Z2,
les relations de Z1 < X1/tan (10°) et Z2 < X2/tan (10°) sont satisfaites.

3. Détecteur de rayonnement selon la revendication 1 ou 2, dans lequel dans un cas où le détecteur de rayonnement (1) est observé à partir de la direction orthogonale à la surface incidente,
une première région (A0) dans laquelle la couche semi-conductrice (11) ne chevauche aucun du premier organe de support (30) et du second organe de support (21) est prévue sur un côté de la région périphérique (PB) adjacent à la limite entre la région de détection (PA) et la région périphérique (PB).

4. Détecteur de rayonnement selon la revendication 3,
dans lequel dans un cas où le détecteur de rayonnement (1) est observé à partir de la direction orthogonale à la surface incidente,
une deuxième région (A1) dans laquelle la couche semi-conductrice (11) chevauche le premier organe de support (30) mais ne chevauche pas le second organe de support (21) est prévue à l'extérieur de la première région (A0).

5. Détecteur de rayonnement selon la revendication 4,
dans lequel dans un cas où le détecteur de rayonnement (1) est observé à partir de la direction orthogonale à la surface incidente,
une troisième région (A3) dans laquelle la couche semi-conductrice (11) chevauche le premier organe de support (30) et le second organe de support (21) est prévue à l'extérieur de la deuxième région (A1).

6. Détecteur de rayonnement selon la revendication 4 ou 5, dans lequel dans un cas où le détecteur de rayonnement (1) est observé à partir de la direction orthogonale à la surface incidente,
une largeur de la première région (A0) est la première distance, et une largeur de la deuxième région (A1) est la seconde distance.

7. Détecteur de rayonnement selon l'une quelconque des revendications 1 à 6,
dans lequel dans une section transversale dans la direction orthogonale à la surface incidente,
une portion d'extrémité du premier organe de support (30) comporte une première surface inclinée qui est inclinée par rapport à la direction orthogonale à la surface incidente, et la première surface inclinée est inclinée dans une direction éloignée de la limite entre la région de détection (PA) et la région périphérique (PB) en étant espacée de la couche semi-conductrice (11).

8. Détecteur de rayonnement selon la revendication 7,
dans lequel la première surface inclinée est inclinée d'un angle supérieur à 10° par rapport à la direction orthogonale à la surface incidente.

9. Détecteur de rayonnement selon l'une quelconque des revendications 1 à 8,
dans lequel dans la section transversale dans la direction orthogonale à la surface incidente,
une portion d'extrémité du second organe de support (21) comporte une seconde surface inclinée qui est inclinée par rapport à la direction orthogonale à la surface incidente, et la seconde surface inclinée est inclinée dans une direction éloignée de la limite entre la région de détection (PA) et la région périphérique (PB) en étant espacée de la couche semi-conductrice (11).

10. Détecteur de rayonnement selon la revendication 9,
dans lequel la seconde surface inclinée est inclinée d'un angle supérieur à 10° par rapport à la direction orthogonale à la surface incidente.

11. Détecteur de rayonnement selon l'une quelconque des revendications 1 à 10 ;
dans lequel la couche semi-conductrice (11) est pourvue d'un circuit de traitement de signal dans la région périphérique (PB).

12. Détecteur de rayonnement selon l'une quelconque des revendications 1 à 11 ;
dans lequel la couche semi-conductrice (11) et le premier organe de support (30) sont reliés l'un à l'autre via une couche adhésive (51A).

13. Détecteur de rayonnement selon l'une quelconque des revendications 1 à 12 ;
dans lequel le premier organe de support (30) et le second organe de support (21) sont reliés l'un à l'autre via une couche adhésive (51B).

14. Système d'imagerie par rayonnement, comprenant :
le détecteur de rayonnement (1) selon l'une quelconque des revendications 1 à 13 ; et
une unité de traitement de signal (806) configurée pour traiter un signal délivré par le détecteur de rayonnement.

15. Système d'imagerie par rayonnement, comprenant :
une source de rayonnement (803) configurée pour émettre un rayonnement, et
le détecteur de rayonnement (1) selon l'une quelconque des revendications 1 à 13 ;
dans lequel la région de détection est configurée pour être irradiée par le rayonnement.
